# EUROPEAN PATENT SPECIFICATION

(11) **EP 1 975 634 B1**
(45) Date of publication and mention of the grant of the patent: **29.09.2010**
(21) Application number: 08104507.2
(22) Date of filing: 16.11.2000
(51) Int. Cl.: G01R 31/3183, G01R 31/3181

(54) **Decompressor/PRPG for Applying Pseudo-Random and Deterministic Test Patterns**
Dekrompressionsgerat/ PRPG Zur Erzeugung Von Pseudo-Zufalligen Und Deterministischen Prufmustern
Decompresseur/PRPG Pour Application De Sequences De Test Pseudo-Aleatoires Et Deterministiques

(30) Priority: 23.11.1999 US 167137 P
(43) Date of publication of application: 01.10.2008
(62) Divisional of application: 00979203.7
(73) Proprietor: Mentor Graphics Corporation, Wilsonville, OR 97070-7777 (US)
(72) Inventor: RAJSKI, Janusz, West Linn, OR 97068 (US); TYSZER, Jerzy, PL-61-249, Poznan (PL); KASSAB, Mark, Wilsonville, OR 97070 (US); MUKHERJEE, Nilanjan, Wilsonville, OR 97070 (US)
(74) Representative: Sessford, Russell

(56) References cited:
- US-A- 5 694 402
- RAJSKI J ET AL: "TEST DATA DECOMPRESSION FOR MULTIPLE SCAN DESIGNS WITH BOUNDARY SCAN" IEEE TRANSACTIONS ON COMPUTERS, IEEE INC. NEW YORK, US, vol. 47, no. 11, November 1998 (1998-11), pages 1188-1200, XP000831123 ISSN: 0018-9340
- ZACHARIA N ET AL: "Decompression of test data using variable-length seed LFSRs" 7 April 1992 (1992-04-07), PROCEEDINGS 13TH IEEE VLSI TEST SYMPOSIUM (CAT. NO.95TH8068) IEEE COMPUT. SOC. PRESS LOS ALAMITOS, CA, USA, PAGE(S) 426 - 433 , XP002303739 ISBN: 0-8186-7000-2 * abstract; figure 6 * section 5 "Hardware Implementation"
- LEW YAN VOON L F C ET AL: "BIST linear generator based on complemented outputs" 7 April 1992 (1992-04-07), VLSI TEST SYMPOSIUM, 1992. '10TH ANNIVERSARY. DESIGN, TEST AND APPLICATION: ASICS AND SYSTEMS-ON-A-CHIP', DIGEST OF PAPERS., 1992 IEEE ATLANTIC CITY, NJ, USA 7-9 APRIL 1992, NEW YORK, NY, USA,IEEE, US, PAGE(S) 137-142 , XP010063459 ISBN: 0-7803-0623-6 * abstract; figure 1 * section 1"Introduction" section 2 "Mixed-Output ALSFM Theory" section 5 "BIST Application"

## Description

### TECHNICAL FIELD

This invention relates generally to testing of integrated circuits and, more particularly, to the generation and application of test data in the form of patterns, or vectors, to scan chains within a circuit-under-test.

### BACKGROUND

Built-in self-test (BIST) is emerging as an attractive alternative to conventional methods of testing microelectronics devices at time of manufacture. In BIST, additional circuitry is added to a circuit-under-test to provide on-chip test-pattern generation, test-response evaluation, and test control. Consequently, BIST is significantly changing the way that integrated circuits are tested. It reduces testing cost by shortening test application time, minimizing the amount of test data that must be stored by an external tester, and reducing tester costs. Its implementation can result in a reduction of the product development cycle and a reduction in the cost of system maintenance.

The basic BIST objectives are on-chip test-pattern generation and test-response compaction. By far the most commonly-used means for generating test patterns on chip are pseudo-random test pattern generators (PRPGs). A PRPG generates a set of test patterns based on an initial value, or seed, loaded into memory elements within the PRPG. The popularity of pseudo-random tests stems from the very simple hardware required to implement the test generation. The two principal forms of PRPGs, which evolved over time and are now commonly in use, are both linear finite state machines: linear feedback shift registers (LFSRs) and one-dimensional linear hybrid cellular automata (LHCAs).

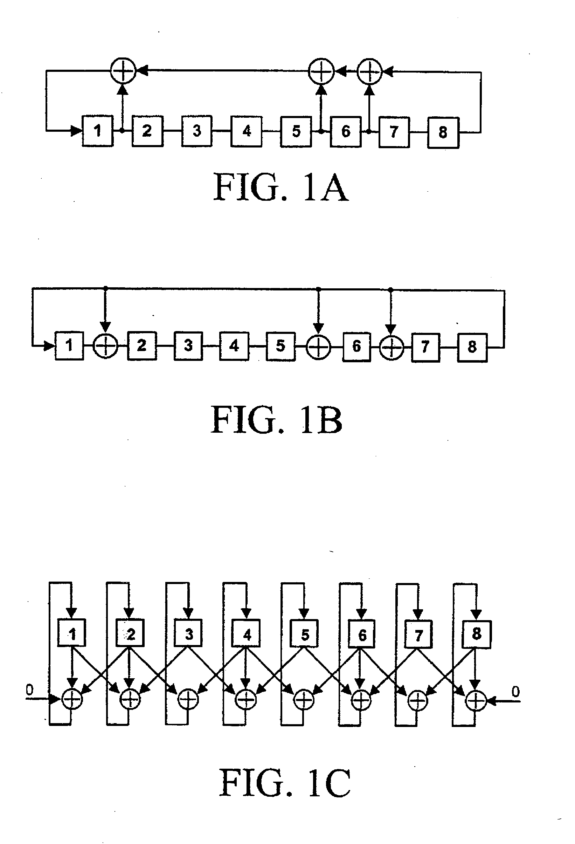

Typically, an LFSR consists of interconnected memory elements (also referred to as flip-flops, stages, cells, etc.) and linear logic elements (such as XOR or XNOR gates). An LFSR of length n can be also represented by its characteristic polynomial *hₙxⁿ* + *h*_{*n*-1}*x*^{*n*-1} + ... + *h₀*, where the term *hᵢxⁱ* refers to the ith flip-flop of the register, such that, if *hᵢ* = 1, then there is a feedback tap taken from this flip-flop. Also, *h*₀ = 1. Fig. 1A shows a type I LFSR, or Fibonacci generator. Fig. 1B shows a type II LFSR, or Galois generator, which uses a shift register with interspersed XOR gates. If an LFSR (of either type) is initialized to a nonzero value, then it can cycle through a number of states before coming back to the initial state. A characteristic polynomial which causes an *n-*bit LFSR to go through all possible 2ⁿ-1 nonzero states is called a primitive characteristic polynomial. The corresponding LFSR is often referred to as a maximum-length LFSR, and the resultant output sequence is termed a maximum-length sequence or *m*-sequence.

An LHCA is a collection of memory cells connected in such a way that each cell is restricted to local neighborhood interactions. These relationships are expressed by rules that determine the next state of a given cell based on information received from its neighbors. For example, if cell *c* can communicate only with its two neighbors, *c*-1 and *c*+1, the so-called rules 90 and 150 are usually employed. The rule 90 can be implemented by a linear logic according to the formula x_{c}(t+1) = x_{c-1}(t) ⊕ x_{c+1}(t), while the rule 150 satisfies the equation x_{c}(t+1) = x_{c-1}(t) ⊕ x_{c}(t) ⊕ x_{c+1}(t), where x_{c}(*t*) represents the state of cell *c* at time *t*. An example of an LHCA is shown in Fig. 1C. This automaton features null boundary conditions. That is, the conditions behave as if the boundary always supplies a zero from beyond the automaton to the inputs to the exterior cells. In an alternative embodiment, the LHCA has cyclic boundary conditions in which the inputs to the exterior cells are connected so that the automaton forms a circle. Contrary to the LHCA with null boundary conditions, the LHCA with cyclic boundary conditions is unable to produce an *m*-sequence.

Although LFSRs and LHCAs can generate a large set of pseudo-random test patterns from one seed, this set seldom provides sufficient fault coverage for a circuit-under-test. At best, 95-96% coverage of stuck-at faults can be achieved, even if test points are added to the circuit-under-test to address random pattern-resistant faults. If higher fault coverage is desired, the pseudo-random test patterns must be supplemented in some way. One supplementing technique is to provide from an external tester additional seeds to the PRPG that target specific faults not detected by the initial seed. Each additional seed generates a set of patterns. Each set, however takes considerable time to generate. Another supplementing technique is to provide fully specified deterministic patterns that bypass the PRPG and target directly the remaining, random pattern resistant faults. This reduces testing time, but increases memory requirements because the external tester memory required to store these "top-up" patterns is significant, often exceeding 50% of the memory required for a complete set of deterministic patterns.

J. Rajski, J. Tyszer, N. Zacharia, "Test data decompression for multiple scan designs with boundary scan", IEEE Transactions on Computers, vol. 47, no. 11, November 1998, pages 1188-1200, discloses a scheme to compress and decompress in parallel deterministic test patterns for circuits with multiple scan chains.

N. Zacharia, J. Rajski, J. Tyszer, "Decompression of test data using variable-length seed LFSRs", Proceedings of the 13th IEEE VLSI Test Symposium, 30 April-3 May 1995, Princeton, NJ (USA), pages 426-433, discloses a scheme to compress and decompress in parallel deterministic test patterns for circuits with multiple scan chains.

L.F.C Lew Yan Voon; C. Dufaza, C. Landrault, "BIST linear generator based on complemented outputs", Proceedings of the 10th IEEE VILSI Test Symposium, 7-9 April 1992, Atlantic City, NJ (USA), pages 137-142, discloses ALFSMs with both complemented and uncomplemented register outputs.

US5694402 discloses a system for structurally testing an integrated circuit device.

### SUMMARY

Accordingly, one aspect of the present invention provides a system for applying test patterns to scan chains in a circuit-under-test comprising: means for applying test patterns to the scan chains; means for providing a set of compressed deterministic test patterns to the test pattern applying means; means for providing an initial value to the test pattern applying means; and means for configuring the test pattern applying means to generate, in a pseudo-random phase of operation, a set of pseudo-random patterns from the initial value and to generate, in a deterministic phase of operation, a set of decompressed deterministic test patterns from the set of compressed deterministic test patterns, wherein the means for applying test patterns to the scan chains further comprises means for combining bits of the compressed deterministic test patterns with bits stored within the means for applying test patterns during the deterministic phase of operation.

Preferably, the system includes means for compressing responses to test patterns captured by the scan chains.

Advantageously, the test pattern applying means includes a linear finite state machine.

Conveniently, the test pattern applying means includes a phase shifter.

Preferably, the system further comprises: circuit logic; and scan chains coupled to the circuit logic and operable to receive test patterns generated by the test pattern applying means and to capture responses to the test patterns generated by the circuit logic.

Advantageously, the means for combining bits comprises XOR or XNOR gates.

Conveniently, the means for applying test patterns comprises means for ensuring that the decompressed deterministic test patterns output from the means for applying test patterns are out of phase.

Another aspect of the present invention provides a method for applying test patterns to scan chains of a circuit-under-test; in a deterministic phase of operation, providing a set of compressed deterministic test patterns to a test pattern applying means; in a pseudo-random phase of operation, providing an initial value to the test pattern applying means; configuring the test pattern applying means to generate, in the pseudo- random phase of operation, a set of pseudo-random patterns from the initial value and to generate, in the deterministic phase of operation, a set of decompressed deterministic test patterns from the set of compressed deterministic test patterns; and in the deterministic phase of operation, combining bits of the compressed deterministic test patterns with bits stored within the test pattern applying means.

Preferably, the combining bits is performed using XOR or XNOR gates.

Advantageously, the set of compressed deterministic test patterns is provided to the test pattern applying means as the test pattern applying means generates the decompressed deterministic test patterns during the deterministic phase of operation.

Conveniently, the method further comprises applying the decompressed deterministic test patterns to the scan chains of the circuit-under-test during the deterministic phase of operation.

Preferably, the applying the decompressed deterministic test patterns to the scan chains of the circuit-under-test occurs as compressed deterministic test patterns are provided to the test pattern applying means during the deterministic phase of operation.

The decompressor/PRPG may include a linear finite state machine that can take various forms, such as a linear feedback shift register or a cellular automaton. The decompressor/PRPG may also include a phase shifter, which may be constructed of linear logic gates.

These and other aspects of the invention will become apparent from the following detailed description of an exemplary embodiment, which makes references to the accompanying drawings.

### BRIEF DESCRIPTION OF THE DRAWINGS

Figs. 1A-C are block diagrams of several well-known types of linear finite state machines that are used to generate pseudo-random test patterns.
Fig. 2 is a block diagram of a test system according to the invention.
Fig. 3 is a block diagram of a circuit that includes a decompressor/PRPG in the form of an LFSM, a phase shifter and scan chains in accordance with the invention.
Fig. 4 shows structure for initializing a decompressor/PRPG.
Fig. 5 shows further detail of a decompressor/PRPG.
Fig. 6 shows the logical expressions for the bits stored in each scan cell in the scan chain of Fig. 3 produced by the decompressor/PRPG and phase shifter.
Figs. 7A-D illustrate alternative embodiments of the LFSM shown in Fig. 3.
Fig. 8 illustrates an embodiment of a 32-bit LFSM.
Fig. 9 illustrates an alternative embodiment of a phase shifter.
Fig. 10 illustrates the use of parallel-to-serial conversion for applying a compressed test pattern to the decompressor/PRPG.

### DETAILED DESCRIPTION

In accordance with the invention, testing of electronic circuits that include scan chains is accomplished in two phases of operation: a pseudo-random phase, in which a decompressor/PRPG generates pseudo-random test patterns for the circuit-under-test, and a deterministic phase, in which the decompressor/PRPG generates deterministic test patterns for the circuit-under test. The two testing phases can be executed in either order and at the substantially the same time (e.g., while the circuit being tested is connected to a tester) or at substantially different times. For example, the deterministic phase may be executed only during manufacture testing if desired, and the pseudo-random phase executed only during field testing. Or both phases can be executed at manufacture testing, and the pseudo-random-phase again executed periodically in the field to ensure that the circuit is maintained. By providing both types of test patterns and by providing the deterministic test patterns in a compressed format, a high level of fault coverage can be achieved with acceptable tester time and memory requirements. In an exemplary embodiment of the invention described herein, the decompressor/PRPG is embedded on a microchip that includes the circuit-under-test and executes the two phases of operation under the joint control of an on-chip BIST controller and an external tester.

Prior to testing, an automatic test pattern generation (ATPG) tool is employed to determine which deterministic test patterns are required to supplement the coverage of the pseudo-random patterns provided by the PRPG. This tool performs fault simulation of all pseudo-random patterns applied to a circuit-under-test and determines thereby which faults are detected and which are not. The faults that are undetected by pseudo-random patterns are then targeted, one by one. For one or more testable faults, the ATPG tool produces a test cube - a partially specified test pattern. For each test cube another tool, a solver of systems of linear equations, may be used to produce a compressed deterministic test pattern. These compressed patterns, when applied to the inputs of the decompressor/PRPG and shifted into the scan chains, produce values consistent with all specified positions of the original test cube.

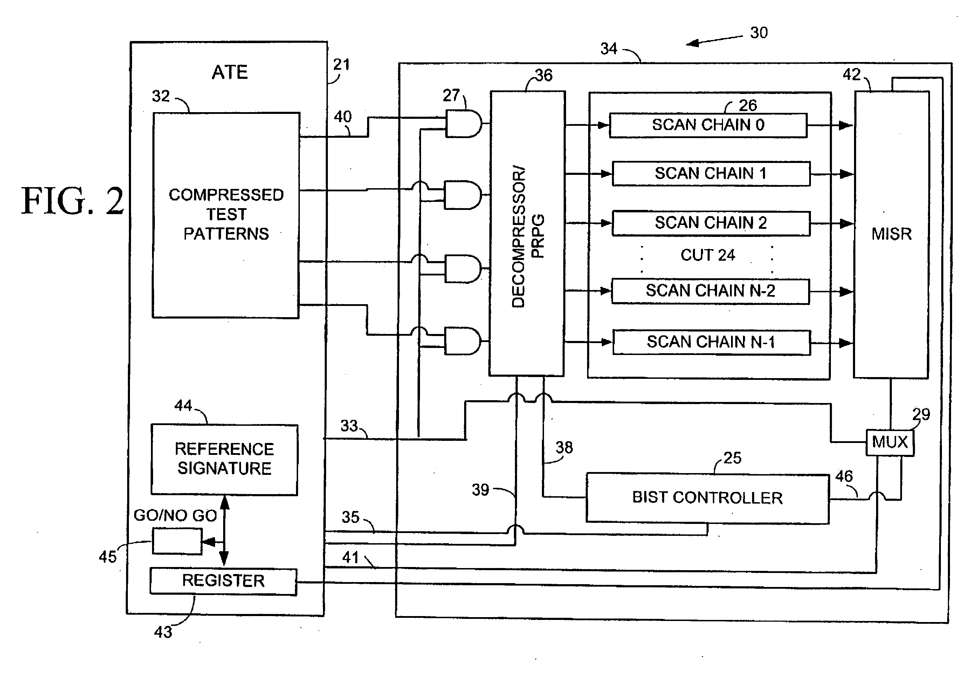

Fig. 2 is a block diagram of a test system 30 according to the invention. The system includes a tester 21 such as external automatic testing equipment (ATE) and a circuit 34 that includes as all or part of it a circuit-under-test (CUT) 24. Embedded within the CUT 24 is circuit logic to be tested and multiple scan chains 26. The circuit 34 also includes a decompressor/PRPG 36 coupled to the scan chains 26, control circuitry such as a BIST controller 25 and a set of one or more AND logic gates 27; a multiplexer 29; and a multiple input signature register (MISR) 42.

The tester 21 is operable to provide a set of compressed deterministic test patterns to the decompressor/PRPG 36 through tester scan channels 40 and the set of AND gates 27. The BIST controller 25 is operable to provide an initial value to the decompressor/ PRPG through a seed/reset line 38. (Alternatively, the tester 21 could be configured to provide this initial value over certain channels.) As will be explained, the control circuitry (the BIST controller and AND gates in this embodiment) are operable to configure the decompressor/PRPG to generate, in a pseudo-random phase of operation, a set of pseudo-random patterns from the initial value for the scan chains and to generate, in a deterministic phase of operation, a set of decompressed deterministic test patterns from the set of compressed deterministic test patterns for the scan chains. Other connections of particular interest in test system 30 include a tester-BIST controller communication line 35 between the controller 25 and the tester 21; a MISR reset select line 33 between the tester 21 and select terminal of the multiplexer 29; and a decompressor reset line 39 between the tester 21 and the decompressor/PRPG 36. Connected to the input terminals of the multiplexer 29 are MISR reset lines 41 and 46 from the tester and BIST controller, respectively. The input terminal of the MISR 42 is coupled to the output terminal of the multiplexer 29, which thus passes a reset signal from either the tester or BIST controller to the MISR. The output terminal of the MISR is coupled to a register 43 within the tester 21, which receives the test response signatures from the MISR for comparison against reference signatures 44 at comparator 45. A decision (Go/No Go) is made based on the comparison whether the CUT 24 contains a fault.

It should be understood that this block diagram represents the functional relationships between the various parts of the test system. The physical design of the test system can vary, depending upon the desired implementation. Conventional elements of such a design, which are not shown, include clock signals, gates, power, etc. and other elements known in the art for carrying out the various functions.

Before describing the structure of the decompressor/PRPG 36 in more detail, the operation of the test system overall and the decompressor/PRPG will first be explained. Assume that the pseudo-random phase of testing is executed first, although the two phases of operation can be executed in either order. The tester 21 notifies the BIST controller via line 35 to initiate the generation of pseudo-random test patterns. Through line 33, the tester also disables AND gates 27 and selects the reset signal on line 46 as the output of multiplexer 29. By disabling the AND gates, the compressed deterministic test patterns 32 from the tester are prevented from influencing the output of the decompressor/PRPG 36. And by selecting the reset signal on line 46, the tester enables controller 25 to reset the MISR before it stores compacted test responses from the scan chains.

The BIST controller 25 responds to the tester notification by transmitting a reset signal on line 38 (reset/seed) to the decompressor/PRPG and a reset signal on line 46 to the MISR 42. In the present embodiment, the initial value (seed) is hard-wired into the decompressor/PRPG, so that a high logic level on line 38 loads the seed into the decompressor/PRPG and a low logic level allows the decompressor/PRPG to generate pseudo-random patterns therefrom. Other ways for resetting and loading the seed are, or course, possible. Once the seed has been loaded, the decompressor/PRPG is clocked to generate a set of pseudo-random test patterns that are applied to the scan chains 26 within the CUT 24 (e.g., two hundred fifty thousand patterns, with perhaps one hundred shifts per pattern to load each into the scan chains). After the circuit logic within the CUT 24 is clocked with each pseudo-random test pattern, the test response to that pattern is captured in the scan chains 26 and passed to the MISR 42, which compresses the multiple test pattern responses into a signature. This signature is then sent to the register 43 within the tester 21 for comparison with a reference signature 44 at comparator 45. If the comparison shows a difference, then a fault exists in CUT 24. The comparison technique can vary. For example, the pseudo-random test patterns and deterministic patterns may be compressed and compared separately to different reference signatures, as just described. Another option is to compress all the test patterns, pseudo-random and deterministic, into one signature and then compare it to a single reference signature.

The BIST controller 25 monitors the number of pseudo-random patterns applied and the shifts through the scan chains by counting the clock pulses controlling the decompressor/PRPG. When the clock pulses indicate that a desired number of the pseudo-random test patterns has been applied and the test results captured in the MISR, the controller notifies the tester 21 via line 35 that the pseudo-random phase of operation is complete. The tester responds by initializing the test system 30 for the deterministic phase. This includes enabling the AND gates 27 via line 33 and selecting the tester MISR reset line 41 as the output of multiplexer 29. The tester also resets the decompressor/PRPG via line 39 in advance of applying the compressed deterministic patterns 32 from its memory and resets the MISR 42 via line 41, if two separate response signatures are generated.

The tester 21 then provides from a set of compressed test patterns 32 of bits, one pattern at a time, through scan channels 40 to the circuit 34. A compressed pattern, as will be described, contains far fewer bits than a fully specified (i.e., uncompressed or conventional) test pattern. A compressed pattern need contain only enough information to recreate deterministically specified bits, whereas a conventional pattern also contains randomly specified bits. Consequently, a compressed pattern is typically 2% to 5% of the size of a conventional test pattern and requires much less tester memory for storage than conventional patterns. As importantly, compressed test patterns require much less time to transmit from a tester to a CUT 24. (Alternatively, uncompressed deterministic test patterns can be used in addition to the compressed patterns, if desired.)

The compressed test patterns 32 are continuously provided from the tester 21 to scan chains 26 within the CUT 24 without interruption (i.e., the decompressing of a compressed deterministic test pattern into a decompressed test pattern of bits occurs as the compressed deterministic test pattern is being provided). Specifically, as a compressed test pattern is being provided by the tester 21 to the input channels of the decompressor/PRPG 36, it decompresses the compressed pattern into a decompressed pattern of bits. The decompressed test pattern is then applied to the scan chains 26 in the CUT 24, and can be done while the compressed test pattern is being provided to the circuit 34 (i.e., the applying of a decompressed deterministic test pattern to scan chains of the circuit-under-test can occur as a compressed deterministic test pattern is being provided). After the circuit logic within the CUT 24 is clocked with a decompressed deterministic test pattern, the test response to that pattern is captured in the scan chains and passed to the MISR 42, where it is compacted as part of a signature. When the response to all of the deterministic patterns have been compressed as a signature, the tester is notified and it requests that the signature be transmitted for comparison with the reference signature 44 at comparator 45. The comparison yields a test result (Go/No Go) that indicates whether the CUT 24 has a fault and should be rejected. As noted above, there may be a single signature or multiple partial signatures for a CUT 24 which are created and compared, depending on design choices.

In a typical configuration, the decompressor/PRPG 36 has one output per scan chain 26, and there are more scan chains than scan channels 40 to the decompressor/PRPG. However, as will be described, other configurations are also possible in which the decompressor/PRPG outputs are fewer than or equal to the input channels. The decompressor/PRPG generates in a given time period a greater number of decompressed bits at its outputs than the number of compressed pattern bits it receives during the same time period. This is an act of decompression, whereby the decompressor/PRPG 36 generates a greater number of bits than are provided to it in a given time period. As explained below, decompression comprises generating one or more bits of a decompressed pattern by logically combining two or more bits of a compressed test pattern. For example, the compressed bits can be combined with an XOR operation or an XNOR operation.

To reduce the data volume of the test response and the time for sending the response to the tester, the circuit 34 may include means for compressing the test response that is read from the scan chains 26. One structure for providing such compression is the multiple input signature register (MISR) 42 described above. Another structure for providing such compression is one or more spatial compactors (not shown), especially for the deterministic test patters. The compressed test responses produced by the compactors are compared one by one with compressed reference responses within the tester. A fault is detected if a reference response does not match an actual response.

The providing of a compressed test pattern to a circuit, its decompression into a decompressed test pattern, and the application of the decompressed test pattern to the scan chains is performed synchronously, continuously, and substantially concurrently. The rate at which each act occurs, however, can vary. All acts can be performed synchronously at a same clock rate if desired. Or the acts can be performed at different clock rates. If the acts are performed at the same clock rate, or if the compressed test patterns are provided and decompressed at a higher clock rate than at which the decompressed test patterns are applied to the scan chains, then the number of outputs of decompressor/PRPG 36 and associated scan chains will exceed the number of input channels of the decompressor/PRPG. In this first case, decompression is achieved by providing more decompressor/PRPG outputs than input channels. If the compressed test patterns are provided at a lower clock rate and decompressed and applied to the scan chains at a higher clock rate, then the number of outputs and associated scan chains can be the same, fewer, or greater than the number of input channels. In this second case, decompression is achieved by generating the decompressed test pattern bits at a higher clock rate than the clock rate at which the compressed test pattern bits are provided.

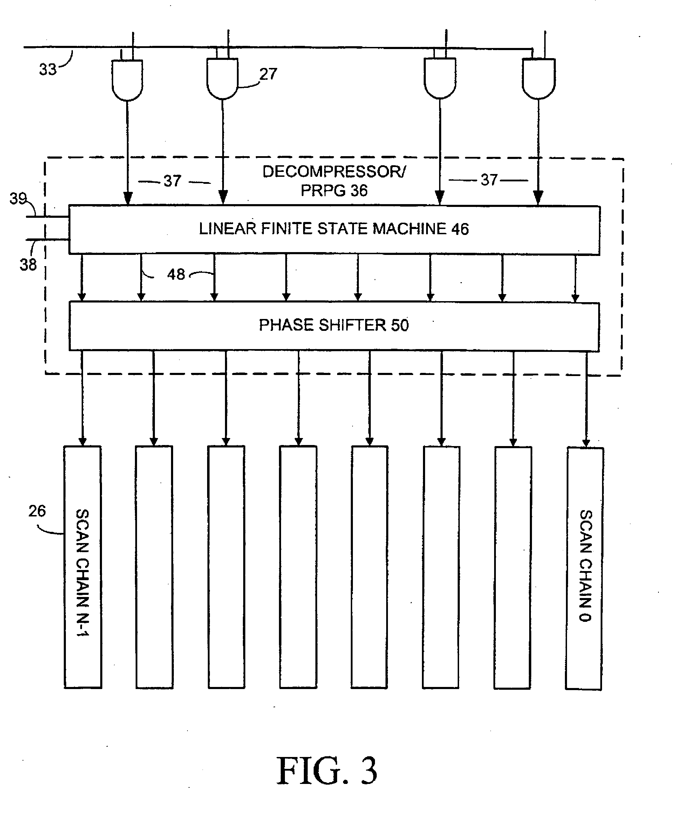

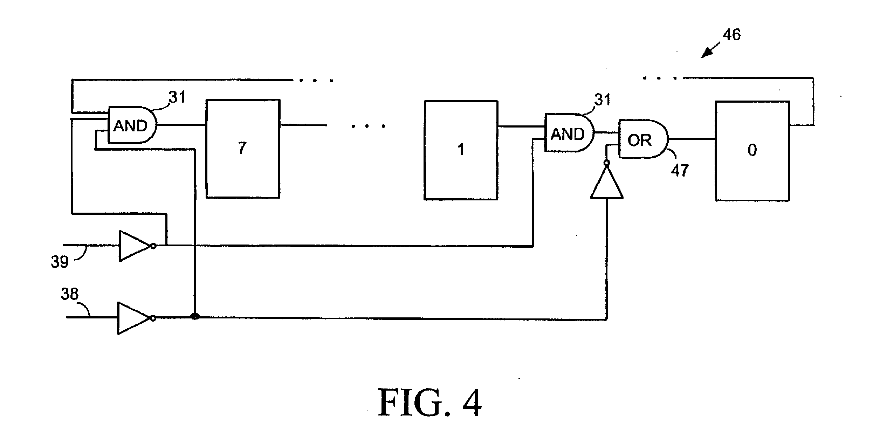

Fig. 3 is a block diagram of one possible embodiment of a decompressor/PRPG 36 in accordance with the invention. The decompressor/PRPG 36 includes a number of input channels 37 through which compressed deterministic test patterns are received from the tester 21 via AND gates 27. The decompressor is also connected to lines 38 and 39 (shown in more detail in Fig. 4). In this embodiment, the decompressor/PRPG is a linear finite state machine (LFSM) 46 coupled, if desired, through its taps 48 to a phase shifter 50. The LFSM through the phase shifter provides highly linearly independent test patterns to the inputs of numerous scan chains 26 in the CUT 24. The LFSM can be built on the basis of the canonical forms of linear feedback shift registers, cellular automata, or transformed LFSRs that can be obtained by applying a number of *m*-sequence preserving transformations. The output of the LFSM is applied through output channels to the phase shifter 50, which ensures that the decompressed pattern bits present within each of the multiple scan chains 26 at any given time do not overlap in pattern (i.e., are out of phase).

The concept of continuous flow decompression described herein rests on the fact noted above that deterministic test patterns typically have only between 2 to 5 % of bits deterministically specified, with the remaining bits randomly filled during test pattern generation. (Test patterns with partially specified bit positions are called test cubes, an example of which appears in Table 2.) These partially specified test cubes are compressed so that the test data volume that has to be stored externally is significantly reduced. The fewer the number of specified bits in a test cube, the better is the ability to encode the information into a compressed pattern. The ability to encode test cubes into a compressed pattern is exploited by having a few decompressor input channels driving the circuit-under-test, which are viewed by the tester as virtual scan chains. The actual CUT 24, however, has its memory elements connected into a large number of real scan chains. Under these circumstances, even a low-cost tester that has few scan channels and sufficiently small memory for storing test data can drive the circuit externally.

Fig. 4 shows one possible means for the tester and BIST controller to initialize the decompressor/PRPG 36. Line 39, which provides a tester reset signal before the application of each deterministic pattern, is coupled to each of the memory elements (stages) of the LFSM 46. When active (high), the signal on line 39 resets each memory element to a zero value through an AND gate 31 coupled to the input terminal of each element. When inactive (low), the reset signal has no effect on the operation of the LFSM. Line 38, which provides a seed/reset signal from the BIST controller, is also coupled to each memory element of the LFSM. The particular coupling at each element determines the binary value of the seed at that element; thus, the seed is "hard-wired" into the LFSM. When the signal on line 38 is high, it loads the seed by setting each element to a binary predetermined value. In Fig. 4, for example, element 7 is set to 0 because the high signal on line 38 disable the adjacent AND gate 31 . Element 0, in contrast, is set to 1 because the OR gate 47 adjacent to the element passes the high signal to the element regardless of the value provided by the output terminal of adjacent element 1. Other initialization means are, of course, possible, such as transmitting a seed from the BIST controller or tester rather than wiring it into the LFSM.

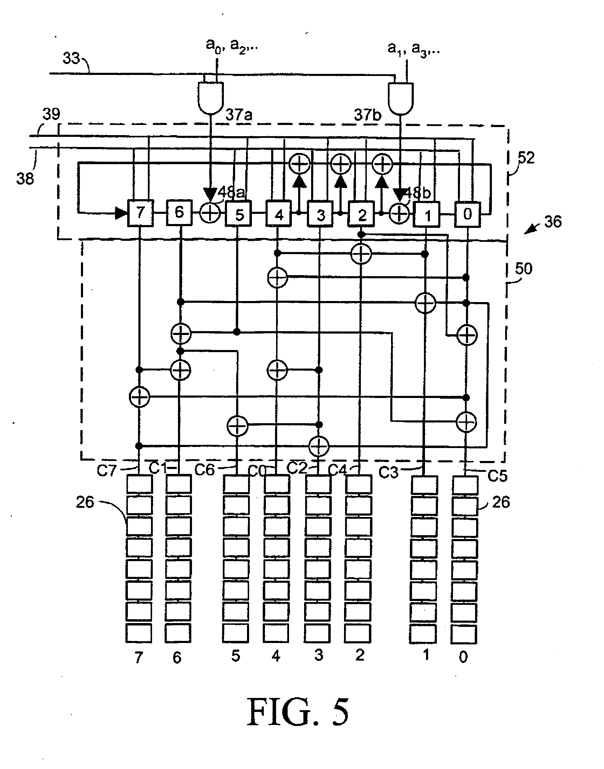

Fig. 5 shows in more detail an exemplary decompressor/PRPG, with an LFSM embodied in an eight-stage type 1 LFSR 52 implementing primitive polynomial *h*(*x*) = *x*⁸ + *x*⁴ + *x*³ + *x*² + 1. Lines 38 and 39 are shown connected to each memory element of the LFSR. The phase shifter 50, embodied in a number of XOR gates, drives eight scan chains 26, each eight bits long. The structure of the phase shifter is selected in such a way that a mutual separation between the shifter's output channels C0-C7 is at least eight bits, and all output channels are driven by 3-input (tap) XOR functions having the following forms:

**Table 1**

| | |
|---|---|
| C₀ = s₄ ⊕ s₃ ⊕ s₀ | C₄ = s₄ ⊕ s₂ ⊕ s₁ |
| C₁ = s₇ ⊕ s₆ ⊕ s₅ | C₅ = s₅ ⊕ s₂ ⊕ s₀ |
| C₂ = s₇ ⊕ s₃ ⊕ s₂ | C₆ = s₆ ⊕ s₅ ⊕ s₃ |
| C₃ = s₆ ⊕ s₁ ⊕ s₀ | C₇ = s₇ ⊕ s₂ ⊕ s₀ |

where *C*ᵢ is the *i*th output channel and *s*ₖ indicates the *k*th stage of the LFSR. Assume that the LFSR 52 is fed every clock cycle through its input channels 37a, 37b and input injectors 48a, 48b (XOR gates) to the second and the sixth stages of the register. The input variables "a" (compressed test pattern bits) received on channel 37a are labeled with even subscripts (a₀, a₂, a₄,..) and the variables "a" received on channel 37b are labeled with odd subscripts (a₁, a₃, a₅,...). Treating these external variables as Boolean, all scan cells can be conceptually filled with symbolic expressions being linear functions of input variables injected by tester 21 into the LFSR 52. Given the feedback polynomial, the phase shifter 50, the location of injectors 48a, b as well as an additional initial period of four clock cycles during which only the LFSR is supplied by test data, the contents of each scan cell within the scan chains 26 can be logically determined.

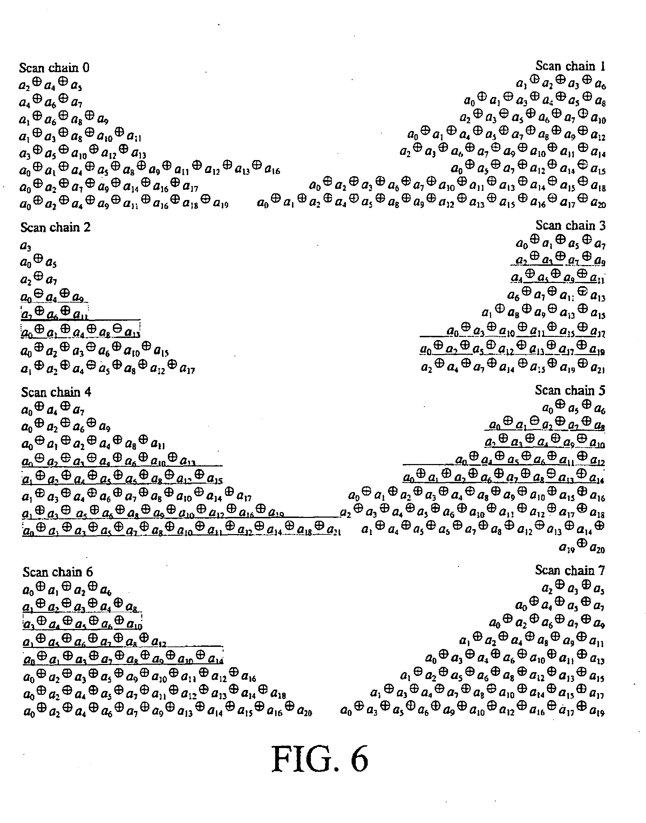

Fig. 6 gives the expressions for the sixty-four cells in the scan chains of Fig. 5, with the scan chains identified as 0 through 7 at the bottom of Fig. 5. The expressions for each scan chain cell in Fig. 6 are listed in the order in which the information is shifted into the chain, i.e., the topmost expression represents the data shifted in first to the chain and thus corresponds to the information stored in the bottom cell of that chain.

Assume that the decompressor/PRPG 36 in Fig. 5 is to generate a test pattern based on the following partially specified test cube in Table 2 (the contents of the eight scan chains are shown here horizontally, with the leftmost column representing the information that is shifted first into the scan chains and which thus resides in the bottom scan chain cell):

**Table 2**

| | |
|---|---|
| x x x x x x x x | scan chain 0 |
| x x x x x x x x | scan chain 1 |
| x x x x 1 1 x x | scan chain 2 |
| x x 0 x x x 1 x | scan chain 3 |
| x x x x 0 x x 1 | scan chain 4 |
| x x 0 x 0 x x x | scan chain 5 |
| x x 1 x 1 x x x | scan chain 6 |
| x x x x x x x x | scan chain 7 |

There are only ten deterministically specified bits; the variable *x* denotes a "don't care" condition. Then a corresponding compressed test pattern can be determined by solving the following system of ten equations from Fig. 5 using any of a number of well-known techniques such as Gauss-Jordan elimination techniques. The selected equations correspond to the ten deterministically specified bits:

**Table 3**

| |
|---|
| *a*₂ ⊕ *a*₆ ⊕ *a*₁₁ = 1 |
| *a*₀ ⊕ *a*₁ ⊕ *a*₄ ⊕ *a*₈ ⊕ *a*₁₃ =1 |
| *a*₄ ⊕ *a*₅ ⊕ *a*₉ ⊕ *a*₁₁ = 0 |
| *a*₀ ⊕ *a*₂ ⊕ *a*₅ ⊕ *a*₁₂ ⊕ *a*₁₃ ⊕ *a*₁₇ ⊕ *a*₁₉ = 1 |
| *a*₁ ⊕ *a*₂ ⊕ *a*₄ ⊕ *a*₅ ⊕ *a*₆ ⊕ *a*₈ ⊕ *a*₁₂ ⊕ *a*₁₅ = 0 |
| *a*₀ ⊕ *a*₁ ⊕ *a*₃ ⊕ *a*₅ ⊕ *a*₇ ⊕ *a*₈ ⊕ *a*₁₀ ⊕ *a*₁₁ ⊕ *a*₁₂ ⊕ *a*₁₄ ⊕ *a*₁₈ ⊕ *a*₂₁ = 1 |
| *a*₂ ⊕ *a*₃ ⊕ *a*₄ ⊕ *a*₉ ⊕ *a*₁₀ = 0 |
| *a*₀ ⊕ *a*₁ ⊕ *a*₂ ⊕ *a*₆ ⊕ *a*₇ ⊕ *a*₈ ⊕ *a*₁₃ ⊕ *a*₁₄ = 0 |
| *a*₃ ⊕ *a*₄ ⊕ *a*₅ ⊕ *a*₆ ⊕ *a*₁₀ = 1 |
| *a*₀ ⊕ *a*₁ ⊕ *a*₃ ⊕ *a*₇ ⊕ *a*₈ ⊕ *a*₉ ⊕ *a*₁₀ ⊕ *a*₁₄ = 1 |

It can be verified that the resulting seed variables *a*₀, *a*₁, *a*_{2,}, *a*₃ and *a*₁₃ are equal to the value of one while the remaining variables assume the value of zero. This seed will subsequently produce a fully specified test pattern in the following form (the initial specified positions are underlined):

**Table 4**

| |
|---|
| 1 0 1 0 0 1 0 0 |
| 1 1 0 0 0 1 0 0 |
| 1 1 1 1 1 1 1 0 |
| 0 0 0 1 0 0 1 1 |
| 1 0 1 0 0 0 0 1 |
| 1 1 0 1 0 0 0 0 |
| 1 1 1 1 1 1 1 1 |
| 0 1 0 0 1 1 0 0 |

The compression ratio is defined as the number of scan cells divided by the number of bits required to place the test pattern within the cells. In the embodiment of Fig. 5, four bits are provided at each of the two injectors to fill the decompressor/PRPG and then eight additional bits are provided at each of the two injectors to complete the generation of content for each of the scan cells. This achieves a compression ratio of 64 / (2 × 8 + 2 × 4) ≈ 2.66. With no compression, the ratio would be less than one (64/ (8 × 8 + 8 × 4) ≈ 0.67).

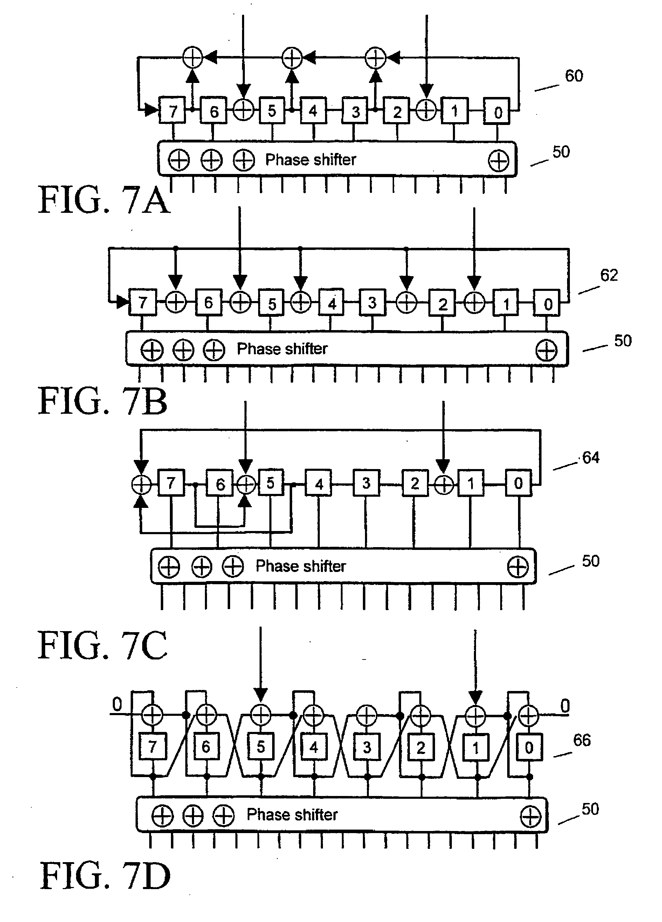

Figs. 7A-D illustrate various embodiments for the LFSM 46 of Fig. 3. Fig. 7A is a type I LFSR 60. Fig. 7B is a type II LFSR 62. Fig 7C is a transformed LFSR 64. And Fig. 7D is a cellular automaton 66. All of them implement primitive polynomials. Except for the cellular automaton 66, in each case the LFSM includes a number of memory elements connected in a shift register configuration. In addition, there are several feedback connections between various memory cells that uniquely determine the next state of the LFSM. The feedback connections are assimilated into the design by introducing injectors in the form of XOR gates near the destination memory elements. The input channels 37a, 37b provide the bits of a compressed pattern to the LFSM through input injectors 48a, b. The injectors are handled similarly as the other feedback connections within the LFSM except that their sources of bits are the input channels. The input channels 37 may have multiple fan-outs driving different LFSM injectors 48 to improve the encoding efficiency.

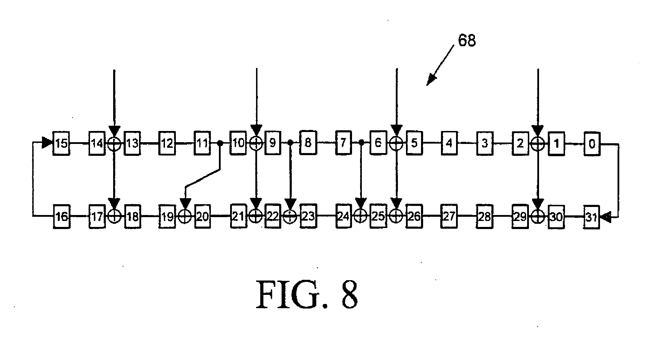

Fig. 8 shows a preferred embodiment of a 32-bit LFSM in the form of a re-timed LFSR 68. The injectors are spaced equally so that the input variables are distributed optimally once they are injected into the LFSM. In practice, the size of the LFSM depends on the number of real scan chains in a circuit, the desired compression ratio of encoding, and on certain structural properties of the circuit-under-test.

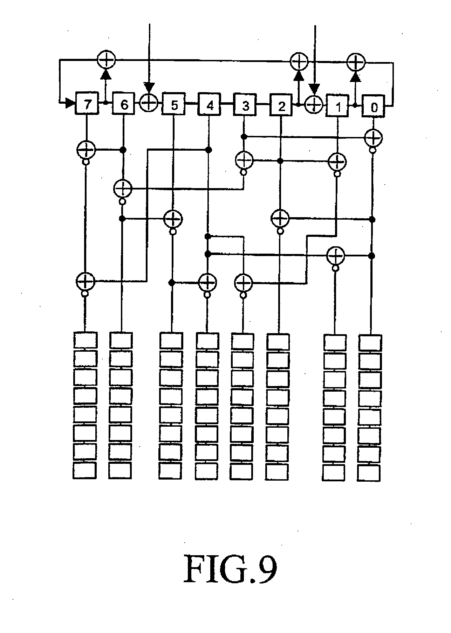

Fig. 9 illustrates an alternative embodiment of a phase shifter 50, constructed with an array of XNOR gates rather than XOR gates. Phase shifters can be constructed with combinations of XNOR and XOR gates as well.

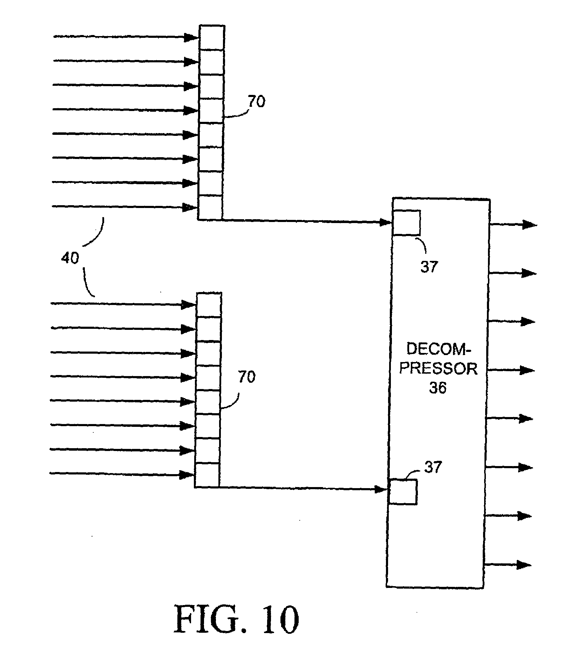

Fig. 10 illustrates the use of parallel-to-serial conversion for applying a compressed test pattern to the decompressor. If the input channels 37 of the decompressor/PRPG 36 are fewer in number than the number of scan channels 40 of the tester 21, it can be advantageous to provide a parallel-to-serial converter such as registers 70 at the input to the decompressor. The registers 70 are clocked such that their contents are shifted out before the next set of bits is applied to the register from the tester 21. The continuous flow of the test patterns is thus preserved.

The process of decompressing a deterministic test pattern will now be described in more detail, with reference to Fig. 3. The LFSM 46 starts its operation from an initial all-zero state provided by a reset signal on line 39 by tester 21. Assuming an *n*-bit LFSM and *m* input injectors, ┌n/m┐ clock cycles may be used to initialize the LFSM before it starts generating bits corresponding to the actual test patterns. After initialization of the LFSM and assuming the appropriate system clocks are running at the same rate, a new bit is loaded in parallel into each scan chain 26 every clock cycle via the phase shifter 50. At this time, the circuit-under-test 24 is operated in the scan mode, so that the decompressed test pattern fills the scan chains 26 with 0s and 1s (and shifts out any previous test response stored there). A small number of bit positions in the scan chains, therefore, get deterministically specified values while the remaining positions are filled with random bits generated by the LFSM. The number of clock cycles for which a test pattern is shifted is determined by the length of the longest scan chain within the circuit, the number being at least as great as the number of cells in the longest scan chain. A scan-shift signal is therefore held high for all the scan chains until the longest scan chain gets the entire test pattern. The shorter scan chains in the circuit are left justified so that the first few bits that are shifted are overwritten without any loss of information.

Patterns from the LFSM may be linearly dependent. In other words, it is possible to determine various bit positions within the two-dimensional structure of multiple scan chains that are significantly correlated. This causes testability problems, as it is often not possible to provide the necessary stimulus for fault excitation to the gates driven by positions that have some form of dependency between them. Consequently, the phase shifter 50 (such as an array of XOR gates or XNOR gates) may be employed at the taps (outputs) of the LFSM to reduce linear dependencies between various bit positions within the scan chains. The XOR logic can be two-level or multilevel depending on the size of the XOR gates. Every scan chain in the CUT 24 is driven by signals that are obtained by XOR-ing a subset of taps 48 from the LFSM. These taps are determined so that the encoding efficiency of the test cubes is still preserved. In addition, the taps are selected in a manner so that all memory cells in the LFSM have approximately equal number of fan-out signals and the propagation delays are suitably optimized. Once a decompressed test pattern is completely loaded into the scan chains during test mode, the CUT 24 is switched to the normal mode of operation. The CUT then performs its normal operation under the stimulus provided by the test pattern in the scan chains. The test response of the CUT is captured in the scan chains. During the capture the LFSM is reset to the all-zero state before a new initialization cycle begins for loading the next test pattern.

Having illustrated and described the principles of the invention in exemplary embodiments, it should be apparent to those skilled in the art that the illustrative embodiments can be modified in arrangement and detail without departing from such principles. For example, the order of steps in the various methods can be varied. In view of the many possible embodiments to which the principles of the invention may be applied, it should be understood that the illustrative embodiment is intended to teach these principles.

## Claims

1. A system for applying test patterns to scan chains (26) in a circuit-under-test comprising:
means (36) for applying test patterns to the scan chains (26);
means (33) for providing a set of compressed deterministic test patterns to the test pattern applying means;
means (38,39)for providing an initial value to the test pattern applying means (36); and
means for configuring the test pattern applying means to generate, in a pseudo-random phase of operation, a set of pseudo-random patterns from the initial value and to generate, in a deterministic phase of operation, a set of decompressed deterministic test patterns from the set of compressed deterministic test patterns,
wherein the means (36) for applying test patterns to the scan chains (26) further comprises means (48a,b) for combining, in the deterministic phase of operation, bits of the compressed deterministic test patterns with bits stored within the means (36) for applying test patterns.

2. The system of claim 1 including means for compressing responses to test patterns captured by the scan chains (26).

3. The system of any of claim 1 or 2 wherein the test pattern applying means (36) includes a linear finite state machine.

4. The system of any of claims 1 to 3 wherein the test pattern applying means (36) includes a phase shifter (50).

5. The system of any of claims 1 to 4, further comprising:
circuit logic (42); and
scan chains (26) coupled to the circuit logic (42) and operable to receive test patterns generated by the test pattern applying means (36) and to capture responses to the test patterns generated by the circuit logic (42).

6. The system of any of claims 1 to 5, wherein the means for combining bits (48a,b) comprises XOR or XNOR gates.

7. The system of any of claims 1-3, 5, or 6, wherein the means (36) for applying test patterns comprises means (50) for ensuring that the decompressed deterministic test patterns output from the means (36) for applying test patterns are out of phase.

8. A method for applying test patterns to scan chains (26) of a circuit-under-test;
in a deterministic phase of operation, providing a set of compressed deterministic test patterns to a test pattern applying means (36);
in a pseudo-random phase of operation, providing an initial value to the test pattern applying means (36);
configuring the test pattern applying means (36) to generate, in the pseudo-random phase of operation, a set of pseudo-random patterns from the initial value and to generate, in the deterministic phase of operation, a set of decompressed deterministic test patterns from the set of compressed deterministic test patterns; and
in the deterministic phase of operation, combining bits of the compressed deterministic test patterns with bits stored within the test pattern applying means (36).

9. The method of claim 8, wherein the combining bits is performed using XOR or XNOR gates (48a,b).

10. The method of claim 8 or 9, wherein the set of compressed deterministic test patterns is provided to the test pattern applying means (36) as the test pattern applying means (36) generates the decompressed deterministic test patterns during the deterministic phase of operation.

11. The method of any of claims 8 to 10, further comprising applying the decompressed deterministic test patterns to the scan chains (26) of the circuit-under-test during the deterministic phase of operation.

12. The method of claim 11, wherein the applying the decompressed deterministic test patterns to the scan chains (26) of the circuit-under-test occurs as compressed deterministic test patterns are provided to the test pattern applying means during the deterministic phase of operation.

## Patentansprüche

1. System zum Anwenden von Prüfmustern auf Scanketten (26) in einer zu prüfenden Schaltung, umfassend:
ein Gerät (36) zum Anwenden von Prüfmustern auf die Scanketten (26),
ein Gerät (33) zum Liefern eines Satzes komprimierter deterministischer Prüfmuster an das Prüfmuster-Anwendungsgerät;
Geräte (38, 39) zum Liefern eines Ausgangswerts an das Prüfmuster-Anwendungsgerät (36); und
Geräte zum Konfigurieren des Prüfmuster-Anwendungsgeräts zum Erzeugen eines Satzes pseudo-zufälliger Muster aus dem Ausgangswert in einer pseudo-zufälligen Betriebsphase und zum Erzeugen eines Satzes dekomprimierter deterministischer Prüfmuster aus dem Satz komprimierter deterministischer Prüfmuster in einer deterministischen Betriebsphase,
wobei das Gerät (36) zum Anwenden der Prüfmuster auf die Scanketten (26) weiterhin Geräte (48a,b) zum Kombinieren von Bits der komprimierten deterministischer Prüfmuster in der deterministischen Betriebsphase umfasst, wobei Bits in dem Gerät (36) zum Anwenden von Prüfmustern gespeichert sind.

2. System nach Anspruch 1, einschließlich Geräten zum Komprimieren von Reaktionen auf von den Scanketten (26) erfasste Prüfmuster.

3. System nach irgendeinem der Ansprüche 1 oder 2, wobei das Prüfmuster-Anwendungsgerät (36) einen linearen endlichen Zustandsautomaten einschließt.

4. System nach irgendeinem der Ansprüche 1 bis 3, wobei das Prüfmuster-Anwendungsgerät (36) einen Phasenverschieber (50) einschließt.

5. System nach irgendeinem der Ansprüche 1 bis 4, weiterhin umfassend:
eine Schaltungslogik (42), und
Scanketten (26), die an die Schaltungslogik (42) gekoppelt und dahingehend funktionsfähig sind, von dem Prüfmuster-Anwendungsgerät (36) erzeugte Prüfmuster zu empfangen und Reaktionen auf die von der Schaltungslogik (42) erzeugten Prüfmuster zu erfassen.

6. System nach irgendeinem der Ansprüche 1 bis 5, wobei das Gerät zum Kombinieren von Bits (48a,b) XOR- oder XNOR-Gates einschließt.

7. System nach irgendeinem der Ansprüche 1 bis 3, 5 oder 6, wobei das Gerät (36) zum Anwenden von Prüfmustern Geräte (50) zum Sicherstellen umfasst, dass die aus dem Gerät (36) zum Anwenden von Prüfmustern ausgegebenen dekomprimierten deterministischen Prüfmuster außer Phase sind.

8. Verfahren zum Anwenden von Prüfmustern auf Scanketten (26) einer zu prüfenden Schaltung;
Liefern eines Satzes komprimierter deterministischer Prüfmuster an ein Prüfmuster-Anwendungsgerät (36) in einer deterministischen Betriebsphase;
Liefern eines Ausgangswerts an das Prüfmuster-Anwendungsgerät (36) in einer pseudo-zufälligen Betriebsphase;
Konfigurieren des Prüfmuster-Anwendungsgeräts (36), um in der pseudo-zufälligen Betriebsphase einen Satz pseudo-zufälliger Muster aus dem Ausgangswert zu erzeugen und in der deterministischen Betriebsphase einen Satz dekomprimierter deterministischer Prüfmuster aus dem Satz komprimierter deterministischer Prüfmuster zu erzeugen; und
Kombinieren von Bits der komprimierten deterministischen Prüfmuster in der deterministischen Betriebsphase, wobei Bits im Prüfmuster-Anwendungsgerät (36) gespeichert sind.

9. Verfahren nach Anspruch 8, wobei das Kombinieren von Bits unter Verwendung von XOR- oder XNOR-Gates (48a,b) durchgeführt wird.

10. Verfahren nach Anspruch 8 oder 9, wobei der Satz komprimierter deterministischer Prüfmuster an das Prüfmuster-Anwendungsgerät (36) geliefert wird, wenn das Prüfmuster-Anwendungsgerät (36) die dekomprimierten deterministischen Prüfmuster während der deterministischen Betriebsphase erzeugt.

11. Verfahren nach irgendeinem der Ansprüche 8 bis 10, weiterhin umfassend das Anwenden der dekomprimierten deterministischen Prüfmuster auf die Scanketten (26) der zu prüfenden Schaltung während der deterministischen Betriebsphase.

12. Verfahren nach Anspruch 11, wobei das Anwenden der dekomprimierten deterministischen Prüfmuster auf die Scanketten (26) der zu prüfenden Schaltung auftritt, wenn komprimierte deterministische Prüfmuster während der deterministischen Betriebsphase an das Prüfmuster-Anwendungsgerät geliefert werden.

## Revendications

1. Un système permettant d'appliquer des séquences de test à des chaînes de balayage (26) dans un circuit sous test, le système comportant :
un dispositif (36) permettant d'appliquer des séquences de test aux chaînes de balayage (26) ;
un dispositif (33) permettant de fournir un ensemble de séquences de test déterministes compressées au dispositif d'application des séquences de test ;
un dispositif (38, 39) permettant de fournir une valeur initiale au dispositif d'application de séquences de test (36) ; et
un dispositif permettant de configurer le dispositif d'application de séquences de test afin de générer, en mode de fonctionnement pseudo-aléatoire, un ensemble de séquences de test pseudo-aléatoires à partir de la valeur initiale et de générer, en mode de fonctionnement déterministe, un ensemble de séquences de test déterministes décompressées à partir de l'ensemble de séquences de test déterministes compressées,
dans lequel le dispositif (36) d'application des séquences de test aux chaînes de balayage (26) comporte également un dispositif (48a,b) permettant de combiner, en mode de fonctionnement déterministe, des bits des séquences de test déterministes compressées avec des bits conservés dans le dispositif (36) pour l'application des séquences de test.

2. Le système de la revendication 1 comprenant un dispositif de compression des réponses aux séquences de test capturées par les chaînes de balayage (26).

3. Le système de l'importe laquelle des revendications 1 ou 2, dans lequel le dispositif d'application des séquences de test (36) comporte une machine à états finis linéaires.

4. Le système de n'importe laquelle des revendications 1 à 3, dans lequel le dispositif d'application des séquences de test (36) comporte un déphaseur (50).

5. Le système de n'importe laquelle des revendications 1 à 4, comportant également :
une logique de circuit (42) ; et
des chaînes de balayage (26) couplées à la logique de circuit (42) et pouvant recevoir les séquences de test générées par le dispositif d'application de séquences de test (36) et enregistrer les réponses aux séquences de test générées par la logique de circuit (42).

6. Le système de n'importe laquelle des revendications 1 à 5, dans lequel le dispositif de combinaison de bits (48a,b) comporte des portes XOR ou XNOR.

7. Le système de n'importe laquelle des revendications 1 à 3, 5 ou 6, dans lequel le dispositif (36) d'application de séquences de test comporte un dispositif (50) permettant d'assurer que les séquences de test déterministes décompressées provenant du dispositif (36) d'application de séquences de test sont déphasées.

8. Une méthode d'application de séquences de test à des chaînes de balayage (26) d'un circuit sous test ;
en mode de fonctionnement déterministe, fournissant un ensemble de séquences de test déterministes compressées à un dispositif d'application de séquences de test (36) ;
en mode de fonctionnement pseudo-aléatoire, fournissant une valeur initiale au dispositif d'application de séquences de test (36) ;
configurant le dispositif d'application de séquences de test (36) afin de générer, en mode de fonctionnement pseudo-aléatoire, un ensemble de séquences pseudo-aléatoires à partir de la valeur initiale et de générer, en mode de fonctionnement déterministe, un ensemble de séquences de test déterministes décompressées à partir de l'ensemble de séquences de test déterministes compressées ; et
en mode de fonctionnement déterministe, en combinant les bits des séquences de test déterministes compressées avec les bits stockés dans le dispositif d'application des séquences de test (36).

9. La méthode de la revendication 8, dans laquelle la combinaison des bits est réalisée à l'aide des portes XOR ou XNOR (48a,b).

10. La méthode de la revendication 8 ou 9, dans laquelle l'ensemble de séquences de test déterministes compressées est fourni au dispositif d'application de séquences de test (36) lorsque le dispositif d'application de séquences de test (36) génère les séquences de test déterministes décompressées en mode de fonctionnement déterministe.

11. La méthode de n'importe laquelle des revendications 8 à 10, comprenant également l'application des séquences de test déterministes décompressées aux chaînes de balayage (26) du circuit sous test en mode de fonctionnement déterministe.

12. La méthode de la revendication 11, dans laquelle l'application des séquences de test déterministes décompressées aux chaînes de balayage (26) du circuit sous test a eu lieu lorsque les séquences de test déterministes compressées sont fournies au dispositif d'application de séquences de test en mode de fonctionnement déterministe.
